# EUROPEAN PATENT SPECIFICATION

(11) **EP 2 789 592 B1**
(45) Date of publication and mention of the grant of the patent: **21.03.2018**
(21) Application number: 12855662.8
(22) Date of filing: 04.12.2012
(51) Int. Cl.: C03C 13/00, B32B 17/10, B32B 27/12, B32B 27/30, B32B 27/34, B32B 27/38, B32B 27/42, D03D 1/00, D03D 15/12, C03C 3/087, C03C 14/00, C03C 25/10, H05K 1/03, D03D 15/00, C03C 25/26, B32B 15/20, B32B 15/092, B32B 15/098, B32B 17/04

(54) **GLASS FABRIC AND GLASS FIBER SHEET MATERIAL USING SAME**
GLASGEWEBE UND GLASFASERBAHNMATERIAL DAMIT
TOILE DE VERRE ET MATIÈRE DE FEUILLE DE FIBRES DE VERRE DANS LAQUELLE ELLE EST UTILISÉE

(30) Priority: 06.12.2011 JP 2011267373
(43) Date of publication of application: 15.10.2014
(73) Proprietor: Nitto Boseki Co., Ltd, Fukushima-shi, Fukushima 960-8161 (JP)
(72) Inventor: NONAKA, Takashi, Fukushima-shi Fukushima 960-8161 (JP); SATO, Takao, Fukushima-shi Fukushima 960-8161 (JP)
(74) Representative: Schön, Christoph
(86) International application number: PCT/JP2012/081405
(87) International publication number: WO 2013/084897

(56) References cited:
- EP-A1- 2 354 104
- EP-A1- 2 354 105
- JP-A- S5 864 243
- JP-A- 2003 171 143
- JP-A- 2003 171 143
- JP-A- 2005 213 656
- JP-A- 2006 282 401
- JP-A- 2009 144 255
- KR-A- 20110 005 279
- US-A1- 2011 000 263
- US-A1- 2011 039 681

## Description

### Technical Field

The present invention relates to glass fabric and glass fiber sheet material using same.

### Background Art

There have hitherto been known, for example, glass fiber sheet materials formed by coating, with a synthetic resin such as a vinyl chloride resin, a fluorine-based resin, an epoxy resin, a phenol resin or a polyimide resin, both front and back sides of a glass fabric obtained by weaving the glass yarns produced by bundling ultra-small diameter glass fibers having a fiber diameter falling within a range from 3 to 6 µm. The glass fiber sheet materials are used in laminate plates as membrane materials for building structure or as base materials for printed wiring substrates.

The membrane materials for building structure are light in weight, thus allow supporting posts to be drastically omitted, and hence are suitable for large span structures having large spacings between supporting posts, such as sport facilities including stadiums, indoor swimming pools and gymnasiums; and such as tent warehouses and large-scale event/exhibition venues. The glass fabrics used for the membrane materials for building structure are desired to be excellent in strength and modulus of elasticity in order to constitute the large span structures.

On the other hand, for the laminate plates as the base materials of printed wiring substrates, ultra-thin glass fibers of 50 µm or less in thickness are generally used. The ultra-thin glass fibers are desired to be excellent in strength and modulus of elasticity from the viewpoint of handleability and dimensional stability.

Glass fibers are generally known to be increased in strength with the decrease of the fiber diameter. Accordingly, the production of glass fiber fabrics woven from fine glass fibers is demanded, for example, in membrane materials for building structure required to be increased in strength and to be light in weight and printed wiring substrates being increasingly reduced in size. However, it has been difficult to stably spin fine glass fibers excellent in strength and modulus of elasticity.

In general, the glass fabrics are formed by weaving glass fibers composed of E-glass; however, the glass fibers composed of E-glass are sometimes insufficient in strength and modulus of elasticity. Accordingly, it is sometimes difficult to use the glass fabrics obtained by weaving the glass fibers composed of E-glass as the glass fiber sheet materials, for example, for the membrane materials for building structure and the laminate plates as the base materials of printed wiring substrates.

In this connection, there have been known glass fabrics obtained by weaving glass fibers composed of S-glass regarded as more excellent in strength than E-glass, in place of E-glass.

However, when a glass composition as the raw material for S-glass is melted into molten glass, and glass fibers are obtained by spinning the molten glass, S-glass has a problem that the 1000-poise temperature of the molten glass is extremely high, and additionally the difference between the 1000-poise temperature of the molten glass and the liquid phase temperature of the molten glass is small.

When the 1000-poise temperature of the molten glass is high, a high temperature is required in the process of melting the glass and the process of forming fibers from the glass, and hence a load, due to thermal load, on the production facilities is large. When the difference between the 1000-poise temperature and the liquid phase temperature is small, in the process during which the molten glass is spun and then cooled to be glass fibers, the glass fibers tend to undergo crystallization (devitrification) even under the effect of slight temperature decrease and a problem of breakage of glass fibers or the like tends to occur. Consequently, when the glass composition as a raw material for S-glass is melted into a molten glass, it is difficult to stably spin glass fibers, falling within a fiber diameter range from 3 to 6 µm, from the molten glass. Accordingly, it is a problem to be solved that although the glass fibers composed of S-glass are excellent in strength, the production conditions of the glass fibers composed of S-glass are severe, and hence it is difficult to mass-produce the glass fibers composed of S-glass.

The "1000-poise temperature" is an index of the standard when a molten glass is spun into fibers, and means the temperature at which the viscosity of the molten glass comes to be 1000 poises. The "liquid phase temperature" means the temperature at which crystals start to precipitate when the temperature of the molten glass is decreased. The temperature range (working temperature range) between the 1000-poise temperature and the liquid phase temperature is a standard indicating the easiness in spinning, and the wider the range, the more easily the stable spinning is performed. The "devitrification" is the phenomenon that crystals precipitate when the temperature of the molten glass is decreased.

Accordingly, a glass composition has been proposed in which the composition of the glass composition as the raw material for S-glass is improved in such a way that the glass composition includes CaO in addition to SiO₂, Al₂O₃ and MgO. As the foregoing glass composition, a glass composition is known which allows the spinning to be easily performed at relatively low temperatures while the working temperature range is being maintained, for example, by decreasing the viscosity on the basis of the decrease of the 1000-poise temperature (see, Patent Literature 1). As the foregoing glass composition, a glass composition is also known in which the difference between the 1000-poise temperature and the liquid phase temperature is large (see, Patent Literature 2). More glass compositions as well as fibers made thereof are also known in the art (see Patent Literatures 3 and 4).

### Citation List

### Patent Literature

Patent Literature 1: Japanese Examined Patent Application Publication No. S62-001337
Patent Literature 2: Japanese Unexamined Patent Application Publication No. 2009-514773
Patent Literature 3: EP 2 354 105 A1
Patent Literature 4: US 2011/000263 A1

### Summary of Invention

### Technical Problem

However, the glass composition described in Patent Literature 1 including CaO as well as SiO₂, Al₂O₃ and MgO tends to undergo devitrification when melted into a molten glass, and it is difficult to stably spin the resulting molten glass. When the glass composition described in Patent Literature 2 is melted into a molten glass, the 1000-poise temperature of the molten glass is high, and hence it is difficult to obtain glass fibers themselves. Accordingly, there is an inconvenience that it is difficult to obtain, from the foregoing conventional glass composition, a glass fabric excellent in strength and modulus of elasticity, and suitable for glass fiber sheet materials.

An object of the present invention is to provide a glass fabric excellent in strength and modulus of elasticity, and suitable for glass fiber sheet materials, by solving such an inconvenience as described above.

Another object of the present invention is to provide glass fiber sheet material using the glass fabric.

### Solution to Problem

In order to achieve such objects as described above, the present invention provides a glass fabric obtained by weaving glass yarns produced by bundling glass fibers, having a fiber diameter falling within a range from 3 to 6 µm, spun from a molten glass prepared by melting a glass composition as a raw material for the glass fibers, wherein the glass fibers have a composition according to claim 1.

According to the present invention, a molten glass is prepared by melting a glass composition as a raw material for the glass fibers having the foregoing composition. Then, a glass fabric is obtained by weaving the glass yarns produced by bundling the glass fibers spun from the molten glass, having a fiber diameter falling within a range from 3 to 6 µm. When the fiber diameter of the glass fibers is smaller than 3 µm, it is difficult to perform spinning itself from the molten glass, and when the fiber diameter of the glass fibers exceeds 6 µm, the glass yarns produced by bundling the glass fibers sometimes undergo a decrease in fiber strength.

The glass fabric of the present invention is formed of the glass fibers having the foregoing composition, and hence can acquire excellent strength and excellent modulus of elasticity, and can be suitably used in the application to constitute glass fiber sheet materials.

In the glass fibers, when the content of SiO₂ is less than 57.0% by mass based on the total amount of the glass fibers, sufficient mechanical strength cannot be obtained as the glass fibers, and when the content of SiO₂ exceeds 63.0% by mass based on the total amount of the glass fibers, the 1000-poise temperature and the liquid phase temperature of the molten glass obtained from the glass composition as the raw material for the glass fibers are high.

In the glass fibers, when the content of Al₂O₃ is less than 19.0% by mass based on the total amount of the glass fibers, sufficient modulus of elasticity cannot be obtained, and when the content of Al₂O₃ exceeds 23.0% by mass based on the total amount of the glass fibers, the liquid phase temperature of the molten glass obtained from the glass composition as the raw material for the glass fibers is high.

In the glass fibers, when the content of MgO is less than 10.0% by mass based on the total amount of the glass fibers, sufficient modulus of elasticity cannot be obtained, and when the content of MgO exceeds 15.0% by mass based on the total amount of the glass fibers, the liquid phase temperature of the molten glass obtained from the glass composition as the raw material for the glass fibers is high.

In the glass fibers, when the content of CaO is less than 5.5% by mass based on the total amount of the glass fibers, the liquid phase temperature of the glass composition is high, and when the content of CaO exceeds 11.0% by mass based on the total amount of the glass fibers, the 1000-poise temperature and the liquid phase temperature of the molten glass obtained from the glass composition as the raw material for the glass fibers are high.

In the glass fibers, when the ratio of the content of MgO to the content of CaO, MgO/CaO is less than 0.8, sufficient modulus of elasticity cannot be obtained, and when the ratio MgO/CaO exceeds 2.0, the liquid phase temperature of the molten glass obtained from the glass composition as the raw material for the glass fibers is high.

When the glass fibers tend to undergo devitrification at the time of spinning the molten glass obtained from the glass composition as the raw material for the glass fibers, a problem of breakage of glass fibers or the like occurs. However, in the present invention, the glass fibers have the foregoing composition, and hence, when the molten glass is decreased in temperature, the crystal precipitating first (the initial phase of devitrification) is a single crystal of cordierite or a mixed crystal composed of cordierite and anorthite. Consequently, the molten glass finds difficulty in crystal precipitation at the liquid phase temperature as compared to the case where the initial phase of devitrification is crystals other than the foregoing crystals. Accordingly, at the time of spinning the molten glass obtained by melting the glass composition as the raw material for the glass fibers, the occurrence of a trouble such as the breakage of the glass fibers can be suppressed, and stable spinning can be performed.

In the present invention, preferably in the molten glass, the 1000-poise temperature is 1350°C or lower, and the difference between the 1000-poise temperature and the liquid phase temperature is preferably 50°C or more. The molten glass can be easily obtained when the 1000-poise temperature is 1350°C or lower. In the molten glass, when the difference between the 1000-poise temperature and the liquid phase temperature is 50°C or more, the working temperature range is widened. Accordingly, even in the case where fine glass fibers having a fiber diameter falling within a range from 3 to 6 µm are spun, the molten glass can be stably spun without undergoing devitrification even when the temperature of the molten glass is decreased due to the effect of the outdoor air temperature.

In the present invention, the glass fibers preferably have a strength of 4.0 GPa or more and a modulus of elasticity of 85 GPa or more. By the strength of the glass fibers being 4.0 GPa or more and a modulus of the elasticity being 85 GPa or more, the glass fabric of the present invention can be suitably used in the application to constitute glass fiber sheet material.

The glass fiber sheet material of the present invention is formed by coating with a synthetic resin both front and back sides of the glass fabric of the present invention. In the glass fiber sheet material of the present invention, as the synthetic resin, for example, a resin selected from the group consisting of a vinyl chloride resin, a fluorine-based resin, an epoxy resin, a phenol resin and a polyimide resin can be used.

### Description of Embodiment

Next, the embodiment of the present invention is described in more detail.

The glass fabric of the present embodiment is obtained by weaving the glass yarns produced by bundling glass fibers, having a fiber diameter falling within a range from 3 to 6 µm, spun from a molten glass prepared by melting a glass composition as a raw material for the glass fibers.

The glass fibers have a composition as disclosed in claim 1.

In the glass fibers, when the content of SiO₂ is less than 57.0% by mass based on the total amount of the glass fibers, sufficient mechanical strength cannot be obtained as the glass fibers, and when the content of SiO₂ exceeds 63.0% by mass based on the total amount of the glass fibers, the 1000-poise temperature and the liquid phase temperature of the molten glass obtained from the glass composition as the raw material for the glass fibers are high. In order to set the 1000-poise temperature of the molten glass composition obtained from the glass composition as the raw material for the glass fibers at 1350°C or lower, the content of SiO₂ falls within a range from 57.0 to 61.0% by mass based on the total amount of the glass fibers.

In the glass fibers, when the content of Al₂O₃ is less than 19.0% by mass based on the total amount of the glass fibers, sufficient modulus of elasticity cannot be obtained, and when the content of Al₂O₃ exceeds 23.0% by mass, the liquid phase temperature of the molten glass obtained from the glass composition as the raw material for the glass fibers is high. In order to obtain excellent modulus of elasticity in the glass fibers and at the same time widen the working temperature range of the molten glass by decreasing the liquid phase temperature of the molten glass, the content of Al₂O₃ falls within a range from 19.0 to 21.0% by mass based on the total amount of the glass fibers.

In the glass fibers, because the content of Al₂O₃ falls within the range from 19.0 to 21.0% by mass, in particular, is in the vicinity of 20.0% by mass based on the total amount of the glass fibers, the initial phase of devitrification in the molten glass obtained from the glass composition as the raw material for the glass fibers can be made to be a single crystal of cordierite or a mixed crystal composed of cordierite and anorthite. When the content of Al₂O₃ is less than 19.0% by mass based on the total amount of the glass fibers, the initial phase of devitrification in the molten glass obtained from the glass composition as the raw material for the glass fibers may not be made to be a single crystal of cordierite or a mixed crystal composed of cordierite and anorthite. Accordingly, in the glass fibers, for the purpose of allowing the initial phase of devitrification in the molten glass obtained from the glass composition as the raw material for the glass fibers to be a single crystal of cordierite or a mixed crystal composed of cordierite and anorthite, the content of Al₂O₃ falls within the vicinity of 19.0% by mass to 21.0% by mass based on the total amount of the glass fibers.

The content of SiO₂/the content of Al₂O₃ is preferably 2.6 to 3.3 in terms of weight ratio. This is because such a range as described above widens the working temperature range at the time of production of the glass fibers, and allows the glass fibers to have sufficient modulus of elasticity. The content of SiO₂/the content of Al₂O₃ is more preferably 2.7 to 3.2 in terms of weight ratio. This is because the weight ratio of the content of SiO₂/the content of Al₂O₃ of 3.2 or less yields the glass fibers having high modulus of elasticity. This is also because the weight ratio of 2.7 or more decreases the liquid phase temperature and at the same time allows the devitrification phenomenon to be suppressed.

In the glass fibers, when the content of MgO is less than 10.0% by mass based on the total amount of the glass fibers, sufficient modulus of elasticity cannot be obtained, and when the content of MgO exceeds 15.0% by mass based on the total amount of the glass fibers, the liquid phase temperature of the molten glass obtained from the glass composition as the raw material for the glass fibers is high. In order to obtain excellent modulus of elasticity in the glass fibers and at the same time widen the working temperature range of the molten glass by decreasing the liquid phase temperature of the molten glass, the content of MgO is less than 11.0% by mass based on the total amount of the glass fibers.

In the glass fibers, when the content of CaO is less than 5.5% by mass based on the total amount of the glass fibers, the liquid phase temperature of the molten glass obtained from the glass composition as the raw material for the glass fibers is high, and when the content of CaO exceeds 11.0% by mass based on the total amount of the glass fibers, the 1000-poise temperature and the liquid phase temperature of the molten glass are high. In order to widen the working temperature range of the molten glass by decreasing the 1000-poise temperature and the liquid phase temperature of the molten glass, the content of CaO falls within a range from 10.0 to 11.0% by mass based on the total amount of the glass fibers.

When the total content of SiO₂, Al₂O₃, MgO and CaO is less than 99.0% by mass, the content of other impurity components is relatively larger, consequently sufficient modulus of elasticity cannot be obtained in the glass fibers, and sufficient working temperature range cannot be ensured in the molten glass obtained from the glass composition as the raw material for the glass fibers. For the purpose of obtaining excellent modulus of elasticity in the glass fibers and at the same time ensuring sufficient working temperature range in the molten glass obtained from the glass composition as the raw material for the glass fibers, the total content of SiO₂, Al₂O₃, MgO and CaO preferably falls within a range of 99.5% by mass or more, and more preferably falls within a range of 99.8% by mass or more based on the total amount of the glass fibers.

In the glass fibers, when the ratio of the content of MgO to the content of CaO, MgO/CaO is less than 0.8, sufficient modulus of elasticity cannot be obtained, and when the ratio MgO/CaO exceeds 2.0, the liquid phase temperature of the molten glass obtained from the glass composition as the raw material for the glass fibers is high. In order to obtain excellent modulus of elasticity in the glass fibers and at the same time widen the working temperature range of the molten glass by decreasing the liquid phase temperature of the molten glass, the ratio of the content of MgO to the content of CaO, MgO/CaO falls within a range from 0.8 to 1.0.

The glass fibers include, as the basic composition, SiO₂, Al₂O₃, MgO and CaO in the contents falling within the foregoing ranges; however, the glass fibers may also include other components inevitably mixed in the glass fibers, for example, because of being included in the raw materials for the respective components. Examples of the other components include: alkali metal oxides such as Na₂O, or Fe₂O₃, TiO₂, ZrO₂, MoO₃ and Cr₂O₃. The content of the other components is less than 1.0% by mass, preferably less than 0.5% by mass and more preferably less than 0.2% by mass based on the total amount of the glass fibers.

The glass fibers having the foregoing composition have a strength of 4.0 GPa or more and a modulus of elasticity of 85 GPa or more.

The glass fibers have the same composition as that of the glass composition as the raw material and that of the molten glass obtained by melting the glass composition.

As the glass composition as the raw material for the glass fibers, glass cullets or glass batch can be used. The molten glass can be obtained by a method of re-melting the glass cullets or by a method of directly melting the glass batch. In the molten glass, specifically the 1000-poise temperature is 1350°C or lower, and the difference between the 1000-poise temperature and the liquid phase temperature is 50°C or more.

The glass fibers can be produced from the molten glass by a heretofore known method. According to the heretofore known method, the molten glass was drawn and spun from tens to thousands of platinum alloy nozzles called a bushing, and the resulting fibers can be taken up to yield glass fibers having a fiber diameter falling within a range from 3 to 6 µm.

When the fiber diameter of the glass fibers is smaller than 3 µm, it is difficult to perform spinning itself from the molten glass, and when the fiber diameter of the glass fibers exceeds 6 µm, when made into glass yarns, sometimes undergo a decrease in fiber strength. For the purpose of obtaining a glass fabric by weaving the glass yarns, the glass fibers preferably has a fiber diameter falling within a range from 3 to 5 µm.

In general, in order to obtain glass fibers having a fiber diameter falling within a range from 3 to 6 µm, the temperature of the platinum alloy nozzles is required to be precisely controlled. In the spinning of the glass fibers having a fiber diameter falling within the foregoing range, the flow rate of the molten glass per one platinum alloy nozzle is extremely small, and the heat amount brought in by the molten glass is small, and hence the temperature of the platinum alloy nozzles is affected by the outdoor air temperature and is easily varied. Accordingly, in the case where the working temperature range of the molten glass is narrow or the rate of crystallization of the molten glass is fast, when the temperature of the platinum alloy nozzles is varied, the molten glass easily undergoes devitrification, and a trouble such as breakage of glass fibers occurs.

However, the molten glass of the present embodiment has the same composition as that of the glass fibers and has a wide working temperature range, and has a slow rate of crystallization; accordingly, even when the temperature of the platinum alloy nozzles is varied, the molten glass concerned does not undergo devitrification and allows the glass fibers having a fiber diameter falling within a range from 3 to 6 µm to be easily obtained.

The glass fibers drawn from the platinum alloy nozzles are imparted with a starch-based sizing agent or a silane coupling agent-containing sizing agent, and are taken up around a plastic core; thus, glass fiber bundles (glass fiber strands) each formed by bundling 50 to 8000 fibers are produced. The glass fiber bundles are rewind around a plastic core while being twisted, and thus the glass yarns are produced. If necessary, a plurality of the glass yarns are assembled and twisted, and then again rewound, and thus twisted glass yarns can also be produced.

The glass fabric of the present embodiment can be obtained by weaving the glass yarns by using a loom heretofore known in itself. Examples of the loom may include a jet loom such as an air-jet loom or a water-jet loom, a shuttle loom and a rapier loom. Examples of the weave implemented with the loom may include a plain weave, a satin weave, a matweave and a twill. The thickness of the glass fabric woven by the loom falls within a range from 10 to 500 µm.

The glass fabric of the present embodiment may also be surface treated with a solution including a silane coupling agent after the glass fabric is heated or cleaned with an aqueous solution.

For the glass fabric of the present embodiment, the glass fibers may be used as a single type, or in combination with one or more types of heretofore known, commercially available fibers selected from, for example, glass fibers, carbon fibers, organic fibers and ceramic fibers or the like.

As described above, the glass fabric of the present embodiment is composed of the glass fibers having a strength of 4.0 GPa or more and a modulus of elasticity of 85 GPa or more, and hence by coating with a synthetic resin both front and back sides of the glass fabric, a glass fiber sheet material having excellent strength and excellent modulus of elasticity can be obtained. In order to obtain the glass fiber sheet material from the glass fabric of the present embodiment, a method heretofore known in itself can be used.

As the synthetic resin, a thermoplastic resin or a thermosetting resin can be used. Examples of the thermoplastic resin include: polyethylene resin, polypropylene resin, polystyrene resin, acrylonitrile/butadiene/styrene (ABS)resin, methacrylic resin, vinyl chloride resin, polyamide resin, polyacetal resin, polyethylene terephthalate (PET) resin, polybutylene terephthalate (PBT) resin, polycarbonate resin, polyphenylene sulfide (PPS) resin, polyether ether ketone (PEEK) resin, liquid crystal polymer (LCP) resin, fluororesin, polyether imide (PEI) resin, polyarylate (PAR) resin, polysulfone (PSF)resin, polyethersulfone (PES) resin and polyamide-imide (PAI) resin, or the like.

In place of the thermoplastic resin, a thermosetting resin may also be used; examples of the thermosetting resin may include unsaturated polyester resin, vinyl ester resin, epoxy resin, melamine resin and phenol resin, or the like. The thermoplastic resin and the thermosetting resin may be used each alone or in combinations of two or more types thereof.

Examples of the heretofore known method may include, for example, in the case of membrane materials for building structure, a method in which the glass fabric of the present embodiment is immersed in a dispersion of the synthetic resin, and then the glass fabric is baked at temperatures falling within a range from about 200 to about 400°C, and alternatively a method in which the sheet of the synthetic resin is superposed on the glass fabric of the present embodiment, and then baked at temperatures falling within a range from about 300 to about 400 °C.

In the membrane material for building structure of the present embodiment, a vinyl chloride resin or a fluorine-based resin is preferably used as the synthetic resin. In particular, examples of the fluorine-based resin may include polytetrafluoroethylene (PTFE) and ethylene-tetrafluoroethylene copolymer (ETFE), or the like. The foregoing synthetic resins may be used each alone or as mixtures of two or more types thereof.

The membrane materials for building structure of the present embodiment can be used as the roof materials of architectural structures such as sport facilities, transportation facilities, commercial facilities, large-scale tent warehouses and large-scale event venues. Examples of the sport facilities may include stadiums, large-scale domes, indoor swimming pools and gymnasiums or the like. Examples of the transportation facilities may include station buildings, terminals, bus terminals, taxi stands, parking lots and bicycle parking lots, or the like. Examples of the commercial facilities may include shopping centers and various leisure facilities, or the like.

Examples of the heretofore known method may include, in the case of the laminate plates as the base materials of printed wiring substrates, a method in which a prepreg is prepared by impregnating a synthetic resin in the glass fabric of the present embodiment, a copper foil is placed on each of the upper surface and the lower surface of a laminate prepared by laminating a predetermined number of the prepreg, or the laminate is laminated on an inner layer core plate, and then the resulting laminate is subjected to a hot-press molding. In the laminate plate, as the synthetic resin to be impregnated in the glass fabric, particularly preferable is a resin selected from the group consisting of an epoxy resin, a phenol resin, a polyimide resin and a fluorine-based resin.

Next, Examples and Comparative Example are presented. The presented examples are not within the scope of the claims, yet they are good for understanding the invention.

### Examples

### [Example 1]

In present Example, first a glass composition was obtained by mixing glass raw materials in such a way that the content of SiO₂ was 60.2% by mass, the content of Al₂O₃ was 20.1% by mass, the content of MgO was 10.1% by mass, the content of CaO was 9.5% by mass and the content of Fe₂O₃ was 0.1% by mass, based on the total amount of the glass composition. In the glass composition, the ratio of the content of MgO to the content of CaO, MgO/CaO is 1.1. The composition of the glass composition is shown in Table 1.

Next, the glass composition was melted in the platinum boat, and while the temperature of the molten glass was being varied, the viscosity of the molten glass was continuously measured by using a rotary B-type viscometer, and the temperature corresponding to the viscosity of 1000 poises was taken as the 1000-poise temperature. It is to be noted that the viscosity measurement was performed according to JIS Z8803-1991.

Next, crushed glass having the composition was placed in a platinum boat and heated in a tubular electric furnace provided with a temperature gradient, covering a range of from 1000 to 1500°C, and the temperature at which crystals started to precipitate was taken as the liquid phase temperature.

Next, the working temperature range was derived as the difference between the 1000-poise temperature and the liquid phase temperature (1000-poise temperature - liquid phase temperature). The 1000-poise temperature, the liquid phase temperature and the working temperature range are shown in Table 2.

Next, the glass composition was heated for melting to a temperature equal to or higher than the 1000-poise temperature, and then the glass composition was allowed to stand for 6 hours at temperatures lower by 100 to 300°C than the liquid phase temperature. Thus, the appearance of the crystals developed on the surface and in the interior of the glass composition was observed, and the devitrification resistance was evaluated on the basis of the three grades A, B and C. A indicates that no crystals precipitate, B indicates that crystals precipitate on a portion of the surface and C indicates that crystals precipitate on the surface and in the interior.

Next, the initial phase portion of the crystals precipitated in the sample used for the measurement of the liquid phase temperature was pulverized, the resulting powder was analyzed with an X-ray diffractometer, and thus the identification of the crystal species of the initial phase of devitrification was performed. The evaluation of the devitrification resistance and the crystal species of the initial phase of devitrification are shown in Table 2.

Next, the glass composition was melted into a molten glass, and the resulting molten glass was spun to yield glass fibers having the fiber diameter of 13 µm. The obtained glass fibers had the same composition as the composition of the glass composition.

Next, by using the monofilament of the glass fibers as a sample, a tensile test was performed and the strength and the modulus of elasticity of the glass fibers were derived.

The glass obtained by melting the glass composition was slowly cooled at a predetermined temperature and for a predetermined period of time, the glass was processed into a size of 4 × 4 × 20 mm, and the processed glass was subjected to a measurement by using a thermomechanical analyzer (TMA) to obtain an average coefficient of linear expansion in a range from 50 to 200°C.

The strength, the modulus of elasticity (E), the average coefficient of linear expansion (α) and the value E/α obtained by dividing the modulus of elasticity E by the average coefficient of linear expansion (α) to be an index for the dimensional stability of the glass fibers are shown in Table 2.

### [Example 2]

In present Example, first a glass composition was obtained by mixing glass raw materials in such a way that the content of SiO₂ was 59.2% by mass, the content of Al₂O₃ was 20.1% by mass, the content of MgO was 12.6% by mass, the content of CaO was 8.0% by mass and the content of Fe₂O₃ was 0.1% by mass, based on the total amount of the glass composition. In the glass composition, the ratio of the content of MgO to the content of CaO, MgO/CaO is 1.6. The composition of the glass composition obtained in present Example is shown in Table 1.

Next, the 1000-poise temperature and the liquid phase temperature were determined, and the working temperature range was derived in exactly the same manner as in Example 1 except that the glass composition obtained in present Example was used. The devitrification resistance was evaluated and the identification of the crystal species of the initial phase of devitrification was performed in exactly the same manner as in Example 1. The results thus obtained are shown in Table 2.

Next, the glass composition was melted into a molten glass, and the resulting molten glass was spun to yield glass fibers. Next, the strength, the modulus of elasticity, the average coefficient of linear expansion and E/α of the glass fibers were derived in exactly the same manner as in Example 1 except that the glass fibers obtained in present Example were used. The results thus obtained are shown in Table 2.

### [Example 3]

In present Example, first a glass composition was obtained by mixing glass raw materials in such a way that the content of SiO₂ was 58.2% by mass, the content of Al₂O₃ was 20.7% by mass, the content of MgO was 12.0% by mass, the content of CaO was 9.0% by mass and the content of Fe₂O₃ was 0.1% by mass, based on the total amount of the glass composition. In the glass composition, the ratio of the content of MgO to the content of CaO, MgO/CaO is 1.3. The composition of the glass composition obtained in present Example is shown in Table 1.

Next, the 1000-poise temperature and the liquid phase temperature were determined, and the working temperature range was derived in exactly the same manner as in Example 1 except that the glass composition obtained in present Example was used. The devitrification resistance was evaluated and the identification of the crystal species of the initial phase of devitrification was performed in exactly the same manner as in Example 1. The results thus obtained are shown in Table 2.

Next, the glass composition was melted into a molten glass, and the resulting molten glass was spun to yield glass fibers. Next, the strength, the modulus of elasticity and the average coefficient of linear expansion and E/α of the glass fibers were derived in exactly the same manner as in Example 1 except that the glass fibers obtained in present Example were used. The results thus obtained are shown in Table 2.

### [Example 4]

In present Example, first a glass composition was obtained by mixing glass raw materials in such a way that the content of SiO₂ was 61.4% by mass, the content of Al₂O₃ was 19.0% by mass, the content of MgO was 12.9% by mass, the content of CaO was 6.5% by mass, the content of Fe₂O₃ was 0.1% by mass and the content of Na₂O was 0.1% by mass, based on the total amount of the glass composition. In the glass composition, the ratio of the content of MgO to the content of CaO, MgO/CaO is 2.0. The composition of the glass composition obtained in present Example is shown in Table 1.

Next, the 1000-poise temperature and the liquid phase temperature were determined, and the working temperature range was derived in exactly the same manner as in Example 1 except that the glass composition obtained in present Example was used. The devitrification resistance was evaluated and the identification of the crystal species of the initial phase of devitrification was performed in exactly the same manner as in Example 1. The results thus obtained are shown in Table 2.

Next, the glass composition was melted into a molten glass, and the resulting molten glass was spun to yield glass fibers. Next, the strength, the modulus of elasticity and the average coefficient of linear expansion and E/α of the glass fibers were derived in exactly the same manner as in Example 1 except that the glass fibers obtained in present Example were used. The results thus obtained are shown in Table 2.

### [Example 5]

In present Example, first a glass composition was obtained by mixing glass raw materials in such a way that the content of SiO₂ was 58.0% by mass, the content of Al₂O₃ was 21.9% by mass, the content of MgO was 10.0% by mass, the content of CaO was 10.0% by mass and the content of Fe₂O₃ was 0.1% by mass, based on the total amount of the glass composition. In the glass composition, the ratio of the content of MgO to the content of CaO, MgO/CaO is 1.0. The composition of the glass composition obtained in present Example is shown in Table 1.

Next, the 1000-poise temperature and the liquid phase temperature were determined, and the working temperature range was derived in exactly the same manner as in Example 1 except that the glass composition obtained in present Example was used. The devitrification resistance was evaluated and the identification of the crystal species of the initial phase of devitrification was performed in exactly the same manner as in Example 1. The results thus obtained are shown in Table 2.

Next, the glass composition was melted into a molten glass, and the resulting molten glass was spun to yield glass fibers. Next, the strength, the modulus of elasticity and the average coefficient of linear expansion and E/α of the glass fibers were derived in exactly the same manner as in Example 1 except that the glass fibers obtained in present Example were used. The results thus obtained are shown in Table 2.

### [Example 6]

In present Example, first a glass composition was obtained by mixing glass raw materials in such a way that the content of SiO₂ was 57.0% by mass, the content of Al₂O₃ was 20.0% by mass, the content of MgO was 12.0% by mass, the content of CaO was 10.9% by mass and the content of Fe₂O₃ was 0.1 % by mass, based on the total amount of the glass composition. In the glass composition, the ratio of the content of MgO to the content of CaO, MgO/CaO is 1.1. The composition of the glass composition obtained in present Example is shown in Table 1.

Next, the 1000-poise temperature and the liquid phase temperature were determined, and the working temperature range was derived in exactly the same manner as in Example 1 except that the glass composition obtained in present Example was used. The devitrification resistance was evaluated and the identification of the crystal species of the initial phase of devitrification was performed in exactly the same manner as in Example 1. The results thus obtained are shown in Table 2.

Next, the glass composition was melted into a molten glass, and the resulting molten glass was spun to yield glass fibers. Next, the strength, the modulus of elasticity and the average coefficient of linear expansion and E/α of the glass fibers were derived in exactly the same manner as in Example 1 except that the glass fibers obtained in present Example were used. The results thus obtained are shown in Table 2.

### [Comparative Example 1]

In present Comparative Example, a glass composition having a composition (the content of SiO₂ was 64.0 to 66.0% by mass, the content of Al₂O₃ was 24.0 to 26.0% by mass and the content of MgO was 9.0 to 11.0%) corresponding to so-called S-glass was obtained.

Next, the 1000-poise temperature and the liquid phase temperature were determined, and the working temperature range was derived in exactly the same manner as in Example 1 except that the glass composition obtained in present Comparative Example was used. The devitrification resistance was evaluated and the identification of the crystal species of the initial phase of devitrification was performed in exactly the same manner as in Example 1. The results thus obtained are shown in Table 2.

Next, the glass composition was melted into a molten glass, and the resulting molten glass was spun to yield glass fibers. Next, the strength, the modulus of elasticity, the average coefficient of linear expansion and E/α of the glass fibers were derived in exactly the same manner as in Example 1 except that the glass fibers obtained in present Comparative Example were used. The results thus obtained are shown in Table 2.

### [Comparative Example 2]

In present Comparative Example, the glass composition having the composition equivalent to so-called E-glass (the content of SiO₂ was 52.0 to 56.0% by mass, the content of Al₂O₃ was 12.0 to 16.0% by mass, the content of MgO was 0 to 6% by mass, the content of CaO was 16 to 25% by mass, the content of Na₂O was 0 to 0.8% by mass and the content of B₂O₃ was 5.0 to 10.0% by mass) was obtained.

Next, the 1000-poise temperature and the liquid phase temperature were determined, and the working temperature range was derived in exactly the same manner as in Example 1 except that the glass composition obtained in present Comparative Example was used. The devitrification resistance was evaluated and the identification of the crystal species of the initial phase of devitrification was performed in exactly the same manner as in Example 1. The results thus obtained are shown in Table 2.

Next, the glass composition was melted into a molten glass, and the resulting molten glass was spun to yield glass fibers. Next, the strength, the modulus of elasticity and the average coefficient of linear expansion and E/α of the glass fibers were derived in exactly the same manner as in Example 1 except that the glass fibers obtained in present Comparative Example were used. The results thus obtained are shown in Table 2.

### [Comparative Example 3]

In present Comparative Example, a glass composition having a composition (the content of SiO₂ was 50.0 to 60.0% by mass, the content of Al₂O₃ was 10.0 to 20.0% by mass, the content of MgO was 0 to 6.0%, the content of CaO was 0 to 4.0% by mass, the content of Na₂O was 0 to 0.5% by mass and the content of B₂O₃ was 20.0 to 30.0% by mass) corresponding to a so-called low dielectric glass was obtained.

Next, the 1000-poise temperature and the liquid phase temperature were determined, and the working temperature range was derived in exactly the same manner as in Example 1 except that the glass composition obtained in present Comparative Example was used. The devitrification resistance was evaluated and the identification of the crystal species of the initial phase of devitrification was performed in exactly the same manner as in Example 1. The results thus obtained are shown in Table 2.

Next, the glass composition was melted into a molten glass, and the resulting molten glass was spun to yield glass fibers. Next, the strength, the modulus of elasticity, the average coefficient of linear expansion and E/α of the glass fibers were derived in exactly the same manner as in Example 1 except that the glass fibers obtained in present Comparative Example were used. The results thus obtained are shown in Table 2.

**[Table 1]**

| | Examples | | | | | |
|---|---|---|---|---|---|---|
| | 1 | 2 | 3 | 4 | 5 | 6 |
| SiO₂ | 60.2 | 59.2 | 58.2 | 61.4 | 58.0 | 57.0 |
| Al₂O₃ | 20.1 | 20.1 | 20.7 | 19.0 | 21.9 | 20.0 |
| MgO | 10.1 | 12.6 | 12.0 | 12.9 | 10.0 | 12.0 |
| CaO | 9.5 | 8.0 | 9.0 | 6.5 | 10.0 | 10.9 |
| Fe₂O₃ | 0.1 | 0.1 | 0.1 | 0.1 | 0.1 | 0.1 |
| Na₂O | 0 | 0 | 0 | 0.1 | 0 | 0 |
| B₂O₃ | 0 | 0 | 0 | 0 | 0 | 0 |
| MgO/CaO | 1.1 | 1.6 | 1.3 | 2.0 | 1.0 | 1.1 |

**[Table 2]**

| | | Examples | | | | | | Comparative Examples | | |
|---|---|---|---|---|---|---|---|---|---|---|
| | | 1 | 2 | 3 | 4 | 5 | 6 | 1 | 2 | 3 |
| 1000-Poise temperature (°C) | | 1343 | 1319 | 1320 | 1349 | 1335 | 1291 | 1470 | 1200 | 1325 |
| Liquid phase temperature (°C) | | 1238 | 1262 | 1230 | 1293 | 1285 | 1239 | 1465 | 1065 | 1070 |
| Working temperature range (°C) | | 105 | 57 | 90 | 56 | 50 | 52 | 5 | 135 | 255 |
| Devitrification resistance | | A | A | A | A | A | A | C | A | A |
| Initial phase of devitrification | | cor/ano | cor | cor | cor | cor/ano | cor | mul | cri | cri |
| Glass fibers | Strength (GPa) | 4.1 | 4.0 | 4.1 | 4.1 | 4.0 | 4.0 | 4.6 | 3.3 | 3.3 |
| | Modulus of elasticity E (GPa) | 86 | 88 | 87 | 86 | 86 | 87 | 86 | 73 | 65 |
| | Average coefficient of linear expansion α (ppm/°C) | 3.9 | 4.0 | 4.0 | 3.9 | 4.0 | 4.0 | 2.8 | 5.6 | 3.3 |
| | E / α | 22.1 | 22.0 | 21.8 | 22.1 | 21.5 | 21.8 | 30.7 | 13.0 | 19.7 |

Devitrification resistance: A indicates that no crystals precipitate, B indicates that crystals precipitate on a portion of the surface and C indicates that crystals precipitate on the surface and in the interior.
Initial phase of devitrification: cor···cordierite, ano···anorthite, mul···mullite, cri···cristobalite

As shown in Table 2, in the molten glass in each of Examples 1 to 6, the 1000-poise temperature was 1350°C or lower, the difference between the 1000-poise temperature and the liquid phase temperature was 50°C or more, and hence the working temperature range was wide; accordingly, spinning can be performed stably within a fiber diameter range from 3 to 6 µm.

When fine fibers having a fiber diameter of 3 to 6 µm are spun, the inflow of the molten glass into the bushing is small, hence the heat amount brought in by the molten glass is small, and the temperature of the molten glass tends to be affected by the temperature variation in the surrounding environment. Accordingly, in the spinning process, the temperature of the molten glass becomes equal to or lower than the liquid phase temperature, and the possibility of the occurrence of crystals becomes higher as compared to glass fibers having large fiber diameters.

However, in the glass composition in each of Examples 1 to 6, the initial phase of devitrification is a single crystal of cordierite or a mixed crystal composed of cordierite and anorthite, and hence, even when the molten glass reaches the liquid phase temperature, the rate of crystallization is slow and crystals are hard to precipitate. Because of the slow rate of crystallization, even when the temperature of the nozzles is decreased, the devitrification resistance is satisfactory and glass fibers can be spun stably.

On the contrary, in S-glass shown in Comparative Example 1, the initial phase of devitrification is mullite, and hence the rate of crystallization is fast and crystals tend to precipitate. Accordingly, S-glass tends to be devitrified by the decrease of the nozzle temperature. Accordingly, S-glass tends to be affected by the variation of the environmental temperature, finds difficulty in stable spinning, and is not suitable for mass production.

When looking at strength and modulus of elasticity, the glass fibers in each of Examples 1 to 6 are formed of glass fibers having a strength of 4.0 GPa or more and a modulus of elasticity of 85 GPa or more, and clearly have excellent strength and excellent modulus of elasticity. On the contrary, S-glass shown in Comparative Example 1 is excellent in strength as compared with the glass fibers of the examples but is equivalent in modulus of elasticity to the glass fibers. However, the contents of SiO₂ and Al₂O₃ exceed the upper limits of the present invention, the 1000-poise temperature is high and the working temperature range is extremely narrow, and hence the spinning conditions are severe. Moreover, the initial phase of devitrification is mullite, hence the devitrification resistance is low and S-glass finds difficulty in stable spinning of glass fibers, and accordingly S-glass is not suitable for mass production of glass fibers.

The glass fibers of Comparative Example 2 and the glass fibers of Comparative Example 3 both had a strength of 3.3 GPa and had a modulus of elasticity of 73 GPa and 65 GPa, respectively; thus, it is clear that the glass fibers are excellent in strength and modulus of elasticity.

This is ascribable to the fact that the glass fibers of Comparative Example 2 had a composition in which the contents of SiO₂ and Al₂O₃ were less than the lower limits of the present invention, and hence the strength of the glass fibers was low, and the fact that the glass fibers of Comparative Example 3 had a composition in which the contents of MgO and CaO were less than the lower limits of the present invention, and hence the modulus of elasticity of the glass fibers was low. Accordingly, it is difficult to produce glass fabrics and glass fiber sheet materials excellent in strength and modulus of elasticity by using the glass fibers composed of the compositions of Comparative Examples 2 and 3.

The glass fibers composed of the glass composition of the examples had an average coefficient of linear expansion of 4.2 or less and a ratio between the modulus of elasticity of glass and the coefficient of linear expansion of glass (E/α) of 20 or more. The ratio between the modulus of elasticity of glass and the coefficient of linear expansion of glass is an index for the dimensional stability, and as generally accepted, the higher the value of this ratio, the better the dimensional stability. As shown in each of Examples, the glass fibers composed of the composition had an E/α value of 20 or more, and it is possible to produce a printed wiring substrate excellent in dimensional stability.

Moreover, compacts were prepared, and the strength of each of the compacts was measured. By using the glass yarns (D900 type) obtained by bundling the glass fibers having a fiber diameter of 5 µm prepared from the glass composition of each of Examples 3 and 4 and Comparative Examples 2 and 3, a plain weave glass fabric (1067 type) was produced with an air-jet loom so as for the weaving density to be 70 yarns/25 mm in the longitudinal direction and 70 yarns/25 mm in the transverse direction. The produced glass fabric was impregnated with an epoxy resin, and the impregnated fabric was dried with a dryer to prepare a prepreg. The prepreg was laminated to form a 30-sheet laminate so as for the glass volume content to be 29%, and then the laminate was hot-press molded with a press to yield a compact.

Each of the compacts thus obtained was processed into a shape of 60 × 25 × 1.2 mm in which the length in the longitudinal direction parallel to the warps of the fabric included in the compact or the length in the transverse direction was 60 mm, a bending test was performed in the longitudinal direction or in the transverse direction, the strength and the modulus of elasticity of the compact were measured, and the measured values were averaged. The results thus obtained are shown in Table 3.

Each of the compacts thus obtained was also processed into a shape of 10 × 15 × 1.2 mm in which the length in the longitudinal direction parallel to the warps of the fabric included in the compact or the length in the transverse direction was 15 mm, each of the processed compacts was subjected to a measurement with a thermomechanical analyzer (TMA), and an average value of the average coefficient of linear expansion in the longitudinal direction and the average coefficient of linear expansion in the transverse direction in a temperature range from 70 to 100°C was derived. The results thus obtained are shown in Table 3.

**[Table 3]**

| | Examples | | Comparative Examples | |
|---|---|---|---|---|
| | 3 | 4 | 2 | 3 |
| Strength (bending test) (MPa) | 518 | 515 | 450 | 375 |
| (%) | (115) | (114) | (100) | (83.3) |
| Modulus of elasticity (bending test) (MPa) | 15.9 | 15.7 | 14.7 | 12.5 |
| (%) | (108) | (107) | (100) | (85.0) |
| Average coefficient of linear expansion (ppm/°C) | 15.5 | 15.4 | 17.4 | 17.7 |
| (%) | (89.1) | (88.5) | (100) | (102) |

In Table 3, the values in parentheses () represent the relative proportions derived when the values for E-glass (the glass of Comparative Example 2) currently generally used for the production of compacts were defined as 100%.

As shown in Table 3, the strength of the compact and the modulus of elasticity of the compact were increased by about 15% and by about 7% or more, respectively, in each of the cases where the compacts were prepared by using the glass fiber fabrics of the examples, as compared with the case of Comparative Example 2 where E-glass was used. The average coefficient of linear expansion of each of the compacts each using the glass fiber fabric of the present invention was decreased by 10% or more, and the compacts each using the glass fiber of the examples were also shown to be excellent in the dimensional stability of the compact.

Accordingly, it is clear that according to the glass fabrics of Examples 1 to 6, glass fiber sheet materials having excellent strength and excellent modulus of elasticity can be easily obtained.

The glass fibers composed of the glass composition of the present invention can be produced as fibers capable of being stably spun, hence are suitable for mass production, and at the same time, are excellent in improvement of the strength, the modulus of elasticity and the dimensional stability of the compact.

## Claims

1. A glass fabric obtained by weaving glass yarns produced by bundling glass fibers having a fiber diameter falling within a range from 3 to 6 µm, spun from a molten glass prepared by melting a glass composition as a raw material for the glass fibers,
wherein the glass fibers have a composition wherein a content of SiO₂ is 57.0 to 61.0% by mass, a content of Al₂O₃ is 19.0 to 21.0% by mass, a content of MgO is 10.0 to 11.0% by mass, a content of CaO is 10.0 to 11.0% by mass, and a content of alkali metal oxides, Fe₂O₃, TiO₂, ZrO₂, MoO₃ and Cr₂O₃ is less than 1.0% by mass, based on a total amount of the glass fibers, and a ratio of the content of MgO to the content of CaO, MgO/CaO falls within a range from 0.8 to 1.0.

2. The glass fabric according to claim 1, wherein a crystal precipitating first, when the molten glass is decreased in temperature, is a single crystal of cordierite or a mixed crystal composed of cordierite and anorthite.

3. The glass fabric according to claim 1 or 2, wherein the molten glass has a 1000-poise temperature, which is a temperature at which the viscosity of the molten glass is 1000 poises, is 1350°C or lower, and a difference between the 1000-poise temperature and a liquid phase temperature, which is a temperature at which crystals start to precipitate when the temperature of the molten glass is decreased, is 50°C or more.

4. The glass fabric according to any one of claims 1 to 3, wherein the glass fibers have a strength of 4.0 GPa or more and a modulus of elasticity of 85 GPa or more.

5. A glass fiber sheet material formed by coating with a synthetic resin both front and back sides of a glass fabric obtained by weaving glass yarns produced by bundling glass fibers having a composition wherein a content of SiO₂ is 57.0 to 61.0% by mass, a content of Al₂O₃ is 19.0 to 21.0% by mass, a content of MgO is 10.0 to 11.0% by mass, a content of CaO is 10.0 to 11.0% by mass, and a content of alkali metal oxides, Fe₂O₃, TiO₂, ZrO₂, MoO₃ and Cr₂O₃ is less than 1.0% by mass, based on a total amount of the glass fibers, and a ratio of the content of MgO to the content of CaO, MgO/CaO falls within a range from 0.8 to 1.0, and having a fiber diameter falling within a range from 3 to 6 µm.

6. The glass fiber sheet material according to claim 5, wherein the synthetic resin is a resin selected from a group consisting of a vinyl chloride resin, a fluorine-based resin, an epoxy resin, a phenol resin, and a polyimide resin.

## Patentansprüche

1. Glasfasergewebe, erhalten durch Weben von Glasgarnen, die durch Bündeln von Glasfasern mit einem in einen Bereich von 3 bis 6 µm fallenden Faserdurchmesser hergestellt werden, welche aus einem geschmolzenen Glas gesponnen sind, das durch Schmelzen einer Glaszusammensetzung als Rohmaterial für die Glasfasern hergestellt wird,
wobei die Glasfasern eine Zusammensetzung aufweisen, worin ein Gehalt an SiO₂ 57,0 bis 61,0 Massen-% beträgt, ein Gehalt an Al₂O₃ 19,0 bis 21,0 Massen-% beträgt, ein Gehalt an MgO 10,0 bis 11,0 Massen-% beträgt, ein Gehalt an CaO 10,0 bis 11,0 Massen-% beträgt und ein Gehalt an Alkalimetalloxiden, Fe₂O₃, TiO₂, ZrO₂, MoO₃ und Cr₂O₃ weniger als 1,0 Massen-%, bezogen auf eine Gesamtmenge der Glasfasern, beträgt und ein Verhältnis des Gehalts an MgO zu dem Gehalt an CaO, MgO/CaO, in einen Bereich von 0,8 bis 1,0 fällt.

2. Glasfasergewebe nach Anspruch 1, wobei ein Kristall, der zuerst ausfällt, wenn die Temperatur des geschmolzenen Glases abnimmt, ein Einkristall von Cordierit oder ein aus Cordierit und Anorthit zusammengesetzter Mischkristall ist.

3. Glasfasergewebe nach Anspruch 1 oder 2, wobei das geschmolzene Glas eine 1000-Poise-Temperatur, d.h. eine Temperatur, bei der die Viskosität des geschmolzenen Glases 1000 Poise beträgt, aufweist, die 1350 °C oder weniger beträgt, und ein Unterschied zwischen der 1000-Poise-Temperatur und einer Flüssigphasentemperatur, d.h. einer Temperatur, bei der die Kristalle beginnen auszufallen, wenn die Temperatur des geschmolzenen Glases abnimmt, 50 °C oder mehr beträgt.

4. Glasfasergewebe nach einem der Ansprüche 1 bis 3, wobei die Glasfasern eine Festigkeit von 4,0 GPa oder mehr und ein Elastizitätsmodul von 85 GPa oder mehr aufweisen.

5. Glasfaserfolienmaterial, gebildet durch Beschichten sowohl der Vorderseite als auch der Rückseite eines Glasfasergewebes, das erhalten wird durch Weben von Glasgarnen, die durch ein Bündeln von Glasfasern hergestellt werden, welche eine Zusammensetzung aufweisen, worin ein Gehalt an SiO₂ 57,0 bis 61,0 Massen-% beträgt, ein Gehalt an Al₂O₃ 19,0 bis 21,0 Massen-% beträgt, ein Gehalt an MgO 10,0 bis 11,0 Massen-% beträgt, ein Gehalt an CaO 10,0 bis 11,0 Massen-% beträgt und ein Gehalt an Alkalimetalloxiden, Fe₂O₃, TiO₂, ZrO₂, MoO₃ und Cr₂O₃ weniger als 1,0 Massen-%, bezogen auf eine Gesamtmenge der Glasfasern, beträgt und ein Verhältnis des Gehalts an MgO zu dem Gehalt an CaO, MgO/CaO, in einen Bereich von 0,8 bis 1,0 fällt, und wobei die Glasfasern einen in einen Bereich von 3 bis 6 µm fallenden Faserdurchmesser aufweisen.

6. Glasfaserfolienmaterial nach Anspruch 5, wobei der synthetische Harz ein Harz ist, das aus einer Gruppe ausgewählt ist, die aus einem Vinylchloridharz, einem auf Fluor basierenden Harz, einem Epoxyharz, einem Phenolharz und einem Polyimidharz besteht.

## Revendications

1. Toile de verre obtenue par le tissage de fils de verre produits par la mise en faisceau de fibres de verre possédant un diamètre de fibre compris dans la gamme allant de 3 à 6 µm, filé à partir d'un verre fondu par la fonte d'une composition de verre en tant que matière première pour les fibres de verre,
dans laquelle les fibres de verre possèdent une composition dans laquelle une teneur en SiO₂ est comprise entre 57,0 et 61,0 % en masse, une teneur en Al₂O₃ est comprise entre 19,0 et 21,0 % en masse, une teneur en MgO est comprise entre 10,0 et 11,0 % en masse, une teneur en CaO est comprise entre 10,0 et 11,0 % en masse, et une teneur en oxydes de métaux alcalins, Fe₂O₃, TiO₂, ZrO₂, MoO₃ et Cr₂O₃ est inférieure à 1,0 % en masse, sur la base d'une quantité totale des fibres de verre, et un rapport de la teneur en MgO à la teneur en CaO, MgO/CaO est compris dans la gamme allant de 0,8 à 1,0.

2. Toile de verre selon la revendication 1, dans laquelle un cristal précipitant en premier, lorsque le verre fondu décroît en température, est un cristal unique de cordiérite ou un cristal mélangé composé de cordiérite et d'anorthite.

3. Toile de verre selon la revendication 1 ou la revendication 2, dans laquelle le verre fondu possède une température de 1000 poises, qui représente une température à laquelle la viscosité du verre fondu est de 1000 poises, est inférieure à 1350 °C, et une différence entre la température de 1000 poises et une température de phase liquide, qui représente une température à laquelle les cristaux commencent à précipiter lorsque la température du verre fondu diminue, est supérieure à 50 °C.

4. Toile de verre selon l'une quelconque des revendications 1 à 3, dans laquelle les fibres de verre possèdent une résistance supérieure à 4,0 GPa et un module d'élasticité supérieur à 85 GPa.

5. Matériau de feuille de fibres de verre formé par le revêtement d'une résine synthétique à la fois sur les côtés avant et arrière d'une toile de verre obtenue par le tissage de fils de verre produit par la mise en faisceau de fibre de verre possédant une composition dans laquelle une teneur en SiO₂ est comprise entre 57,0 et 61,0 % en masse, une teneur en Al₂O₃ est comprise entre 19,0 et 21,0 % en masse, une teneur en MgO est comprise entre 10,0 et 11,0 % en masse, une teneur en CaO est comprise entre 10,0 et 11,0 % en masse, et une teneur en oxydes de métaux alcalins, Fe₂O₃, TiO₂, ZrO₂, MoO₃ et Cr₂O₃ est inférieure à 1,0 % en masse, sur la base d'une quantité totale des fibres de verre, et un rapport de la teneur en MgO à la teneur en CaO, MgO/CaO compris dans la gamme allant de 0,8 à 1,0, et possédant un diamètre de fibre compris dans la gamme allant de 3 à 6 µm.

6. Matériau de feuille de fibres de verre selon la revendication 5, dans lequel la résine synthétique est une résine choisie parmi un groupe constitué d'une résine de chlorure de vinyle, d'une résine à base de fluor, d'une résine époxy, d'une résine de phénol, et d'une résine de polyimide.
